# EUROPÄISCHE PATENTSCHRIFT

(11) **EP 2 280 907 B1**
(45) Veröffentlichungstag und Bekanntmachung des Hinweises auf die Patenterteilung: **15.07.2015**
(21) Anmeldenummer: 09737935.8
(22) Anmeldetag: 13.03.2009
(51) Int. Cl.: B81C 1/00, H01H 59/00

(54) **MIKROMECHANISCHES BAUTEIL MIT GETEMPERTER METALLSCHICHT UND VERFAHREN ZU DESSEN HERSTELLUNG**
MICROMECHANICAL COMPONENT HAVING AN ANNEALED METAL LAYER AND METHOD FOR PRODUCING THE SAME
COMPOSANT MICROMÉCANIQUE AYANT UNE COUCHE METALLIQUE RECUITE ET SON PROCÉDÉ DE PRODUCTION

(30) Priorität: 28.04.2008 DE 102008001422
(43) Veröffentlichungstag der Anmeldung: 09.02.2011
(73) Patentinhaber: Robert Bosch GmbH, 70442 Stuttgart (DE)
(72) Erfinder: BUCK, Thomas, 71732 Tamm (DE); STUMBER, Michael, 70825 Korntal-Muenchingen (DE)
(86) Internationale Anmeldenummer: PCT/EP2009/052970
(87) Internationale Veröffentlichungsnummer: WO 2009/132891

(56) Entgegenhaltungen:
- DE-A1-102005 004 877
- SHIN J-W ET AL: "Investigation of stress in aluminum thin film for MEMS applications" PROCEEDINGS OF THE SPIE - THE INTERNATIONAL SOCIETY FOR OPTICAL ENGINEERING, SPIE, US LNKD- DOI:10.1117/12.448857, Bd. 4593, 17. Dezember 2001 (2001-12-17), Seiten 263-273, XP007912474 ISSN: 0277-786X
- GANGULEE ET AL: "Strain-relaxation in thin films on substrates" ACTA METALLURGICA, PERGAMON PRESS, US LNKD- DOI:10.1016/0001-6160(74)90008-X, Bd. 22, Nr. 2, 1. Februar 1974 (1974-02-01), Seiten 177-183, XP024028033 ISSN: 0001-6160 [gefunden am 1974-02-01]
- LEE HOO-JEONG ET AL: "Study on the strength and elongation of free-standing Al beams for microelectromechanical systems applications" APPLIED PHYSICS LETTERS, AIP, AMERICAN INSTITUTE OF PHYSICS, MELVILLE, NY, US LNKD- DOI:10.1063/1.1646765, Bd. 84, Nr. 6, 9. Februar 2004 (2004-02-09), Seiten 915-917, XP012062046 ISSN: 0003-6951

## Beschreibung

### Stand der Technik

Die vorliegende Erfindung betrifft einen mikromechanischen Drucksensor und Verfahren zu dessen Herstellung. Sie betrifft insbesondere ein Verfahren zur Herstellung eines mikromechanischen Drucksensors, wobei ein Substrat zumindest mit einer Metallschicht sowie einer SiGe umfassenden Opferschicht strukturiert wird. Solch eine Metallschicht ist ganz oder teileweise als eine Membran ausgeführt.

Hochfrequenz-Schalter für Anwendungen im Gigahertz-Bereich, wie sie beispielsweise in der Radartechnik auftreten, können mittels mikro-elektro-mechanischer Systemtechnologie (MEMS-Technologie) hergestellt werden. Als Schaltelement dient hierbei eine metallische Brücke, die über mikrosystemtechnische Prozesse (MST-Prozesse) freitragend gestaltet und elektrostatisch geschaltet, also herangezogen, wird. Das Freistellen dieser Brücke hat sich als technisch anspruchsvoll erwiesen und wurde bislang mittels Opferlacktechnik realisiert.

DE 10 2005 004 877 A1 offenbart ein Herstellungsverfahren für ein mikromechanisches Bauelement. Hierin wird zunächst ein leitfähiges Substrat und dann ein inselartiger Bereich einer Opferschicht über einer Vorderseite des Substrats bereitgestellt. Der nächste Schritt ist das Vorsehen mindestens einer leitfähigen Schicht gewölbt über der Opferschicht, wobei die leitfähige Schicht gegenüber dem Substrat elektrisch isoliert ist. Danach wird eine Mehrzahl von durch das Substrat laufenden Perforationsöffnungen vorgesehen, welche sich bis mindestens zum inselartigen Bereich der Opferschicht erstrecken. Die Opferschicht wird durch einen ersten Ätzprozess von einer Rückseite des Substrats her durch die Perforationsöffnungen zum Schaffen eines Hohlraums entfernt, der eine elastisch auslenkbare Membran mit mindestens der leitfähigen Schicht freilegt, die gewölbt über einer Vorderseite des Substrats vorgesehen ist. Die Opferschicht kann aus SiGe bestehen, welche mit einem Ätzgas aus der Gruppe ClF₃, ClF₅, BrF₃, XeF₂, IF₃ oder IF₅ selektiv geätzt wird.

Gemäß der Lehre der DE 10 2005 004 877 A1 kann die leitfähige Schicht aus Metall vorgesehen sein. Jedoch weisen viele in der Halbleitertechnik eingesetzte Metallisierungen wie zum Beispiel Aluminium oder Aluminium-Legierungen metallintrinsische Hysterese-Effekte auf. Somit sind solche Bauteile nur für Kleinsignalanwendungen, also für Arbeitssituationen unter geringen mechanischen Auslenkungen, geeignet. Ein Einsatz als Drucksensor scheidet für solche Bauteile aus. Es bleibt der Einsatz als Mikrofon oder Schallwandler.

Bei Drucksensoren handelt es sich um Messinstrumente mit entsprechend hohen Anforderungen an die Messgenauigkeit. Drucksensoren sind nicht auf den Kleinsignalfall beschränkt, sondern müssen größere Membranauslenkungen treu in ein elektrisches Signal umwandeln. Hysteresen sind dabei in der Regel unzulässig. Laut DE 10 2005 004 877 A1 dürfen aus diesem Grund als Bestandteile der druckempfindlichen Membran in einem Drucksensor nur hysteresefreie Materialien, beispielsweise Polysilizium, verwendet werden.

Wünschenswert wäre es jedoch, bei der Fertigung eines mikromechanischen Bauteils wie beispielsweise eines Drucksensors bei der Materialauswahl insbesondere für die Membran weitere Optionen zur Verfügung zu haben. Insbesondere ist es wünschenswert, einen mechanisch spannungsarmen oder spannungsfreien Drucksensor zu erhalten.

### Offenbarung der Erfindung

Erfindungsgemäß vorgeschlagen wird ein Verfahren zur Herstellung von mikromechanischen Drucksensoren, wobei ein Substrat zumindest mit einer Metallschicht sowie einer SiGe umfassenden Opferschicht strukturiert wird und wobei weiterhin die Opferschicht durch Ätzen mit einer fluorhaltigen Verbindung mindestens teilweise wieder entfernt wird. Das erfindungsgemäße Verfahren zeichnet sich dadurch aus, dass vor dem Ätzen der Opferschicht das Substrat, welches die Opferschicht und die Metallschicht trägt, bei einer Temperatur von ≥ 100 °C bis ≤ 400 °C getempert wird.

Das Substrat kann elektrisch leitfähig sein. So kann es beispielsweise ein in der Mikrosystemtechnik häufig verwendeter Siliziumwafer sein. Wenn erforderlich, kann das Substrat zusätzlich mit einer Oxidschicht bedeckt werden,

Das Strukturieren des Substrats bezeichnet allgemein das Gestalten von Strukturen auf dem Substrat. Dieses kann unter anderem durch Gasphasenabscheidung, galvanische Verfahren, Mikrostempeln oder anderen dem Fachmann geläufigen Verfahren geschehen. Aufgebrachte Strukturen können beispielsweise Leiterbahnen, Brücken, Membranen, Spiegel, Kontaktstellen, Opferstrukturen, intermediäre Strukturen und dergleichen sein.

Die Metallschicht kann direkt auf dem Substrat aufgetragen werden, auf anderen, zuvor hergestellten anderen Metallschichten wie zum Beispiel elektrischen Kontakten, auf dielektrischen Schichten oder auf Opferschichten.

Die Opferschicht umfasst erfindungsgemäß SiGe als Opfermaterial. Vorteilhaft hieran ist zunächst, dass die Abscheidung und somit die Dicke der SiGe-Schicht sowie damit zusammenhängend ihre Strukturierung sehr präzise erfolgen kann. Die Opferschicht kann im Laufe des Verfahrens durch Ätzen mit fluorhaltigen Verbindungen wieder entfernt werden, wodurch Vertiefungen oder Hohlräume geschaffen werden können. Vorteilhafterweise beträgt die Zusammensetzung der SiGe-Opferschicht hierbei Si₁₋ₓGeₓ. wobei x einen Wert von ≥ 0,1 bis ≤ 0,9 oder von ≥ 0,2 bis ≤ 0,5 einnehmen kann. Die Verwendung von SiGe-Opferschichten hat mehrere Vorteile. Beim Ätzen mit fluorhaltigen Verbindungen kann das Material der Opferschicht in gasförmige Silizium- und Germaniumfluoride überführt werden. Ist die fluorhaltige Ätz-Verbindung ebenfalls gasförmig, lassen sich Rückstände auf dem Substrat so vermeiden. Weiterhin weist das Ätzen des Opfermaterials SiGe gegenüber dem häufig als Substrat verwendetem Silizium eine hohe Selektivität auf. Sie kann in einem Bereich von 4000:1 bis 10000:1 liegen.

Vor dem Ätzschritt der Opferschicht, also wenn Metallschicht und Opferschicht bereits auf dem Substrat strukturiert sind, wird diese Anordnung im erfindungsgemäßen Verfahren getempert. Erfindungsgemäß wurde gefunden, dass durch das Tempern die Hystereseeigenschaften der Metallschicht so weit verringern lassen, dass solche Membranen über den Kleinsignalfall hinaus eingesetzt werden können. Insbesondere können mikromechanische Drucksensoren mit Metallmembranen konstruiert werden. Weiterhin können die Membraneigenschaften reproduzierbarer gestaltet werden. Das Tempern kann bei einer Temperatur von ≥ 100 °C bis ≤ 400 °C stattfinden. Es ist auch möglich, dass die Temperatur in einem Bereich von ≥ 250 °C bis ≤ 400 °C oder von ≥ 300 °C bis ≤ 350 °C liegt. Das Tempern bei solchen Temperaturen ist bei Schichten in Opferlacktechnik nicht möglich, da der Schmelzpunkt des Lacks überschritten würde. Weiterhin kann durch das Tempern insgesamt ein mechanisch spannungsarmer oder spannungsfreier Drucksensor erhalten werden.

In einer Ausführungsform des Verfahrens umfasst die Metallschicht Aluminium, Gold, Tantal, Titan und/oder Titan-Wolfram. Hierin eingeschlossen sind auch Legierungen der vorgenannten Metalle mit anderen Komponenten. Vorteilhaft insbesondere an der Verwendung von Aluminium ist, dass dieses Material ebenfalls mittels Ätzverfahren bearbeitet werden kann. Vorteilhafterweise betrifft diese Wahl der Metalle diejenige Schicht, welche im fertigen Drucksensor eine Membran bildet.

In einer weiteren Ausführungsform des Verfahrens ist die zum Ätzen verwendete fluorhaltige Verbindung ausgewählt aus der Gruppe umfassend ClF₃, ClF₅, BrF₃, BrF₅, IF₃, IF₅, IF₇ und/oder XeF₂. Vorteilhafterweise liegen diese Verbindungen während des Ätzschrittes in gasförmiger Form vor. Insbesondere mit ClF₃ gelingt es, SiGe-Opferschichten mit hoher Selektivität gegenüber Silizium und siliziumbasierten dielektrischen Schichten zu ätzen. Beim Ätzen kann beispielsweise ein Druck von ≥ 5 Pa bis ≤ 1000 Pa und vorzugsweise von ≥ 10 Pa bis ≤ 100 Pa angelegt werden. Die Wafertemperatur hierbei kann in einem Bereich von ≥ -30 °C bis ≤ 40 °C und vorzugsweise von ≥ -18 °C bis ≤ -22 °C liegen. Der Ätzvorgang mit ClF₃ ist weiterhin sehr schonend für empfindliche Strukturen auf dem Substrat.

In einer weiteren Ausführungsform des Verfahrens wird das Strukturieren des Substrats mit der Metallschicht dergestalt ausgeführt, dass die Metallschicht zumindest teilweise auf die Opferschicht aufgetragen wird. Dieses bedeutet, dass nach dem Entfernen der Opferschicht unter der Metallschicht ein Leerraum aufgebaut wird. Folglich kann die Metallschicht dann als Membran eingesetzt werden.

Gegenstand der vorliegenden Erfindung ist weiterhin ein mikromechanischer Drucksensor, hergestellt durch ein Verfahren gemäß der vorliegenden Erfindung. Dieser mikromechanische Drucksensor weist folglich eine dehnbare oder bewegliche Metallschicht auf, deren intrinsische Spannung einen entscheidenden Einfluss auf die gewünschte Funktion des Bauteils haben kann.

In einer Ausführungsform des mikromechanischen Drucksensors umfasst dieser eine Metallschicht, wobei das Material der Metallschicht in einem polykristallinen Gefüge vorliegt und wobei ≥ 90% der Kristallite eine Größe von ≥ 1 µm bis ≤ 100 µm aufweisen. Die Kristallite können auch in einem Größenbereich von ≥ 5 µm bis ≤ 80 µm oder von ≥ 15 µm bis ≤ 60 µm vorliegen. Die Größe der Kristallite kann beispielsweise mittels Elektronenmikroskopie bestimmt werden und ist als die größte Ausdehnung des Kristalliten zu verstehen. Solch ein Gefüge weist gegenüber einem nanokristallinen Gefüge, wie es direkt beispielsweise nach dem Aufsputtern eines Metalls vorliegen kann, eine geringere intrinsische mechanische Spannung auf.

In einer weiteren Ausführungsform des mikromechanischen Drucksensors umfasst die Metallschicht Aluminium, Gold, Tantal, Titan und/oder Titan-Wolfram. Hierin eingeschlossen sind auch Legierungen der vorgenannten Metalle mit anderen Komponenten. Vorteilhaft insbesondere an der Verwendung von Aluminium ist, dass dieses Material ebenfalls mittels Ätzverfahren bearbeitet werden kann. Vorteilhafterweise betrifft diese Wahl der Metalle diejenige Schicht, welche im fertigen Drucksensor eine Membran bildet.

In einer erfindungsgemäßen Ausführungsform des mikromechanischen Drucksensors ist die Metallschicht zumindest teilweise als Membran ausgeführt. Unter Membran ist hierbei eine Anordnung zu verstehen, welche über einem Leerraum angeordnet ist. Die Membran kann über einem abgeschlossenen Leerraum stehen oder über einem offenen. Weiterhin kann sie an einer oder an mehreren Seiten abgestützt sein. Mit eingeschlossen sind auslenkbare Zungen, welche an einem Ende dauerhaft kontaktiert sind und welche erst bei Auslenkung einen zweiten Kontakt zu einer Leiterbahn aufbauen.

Ein mikromechanischer Drucksensor mit einer erfindungsgemäß getempertem Metallmembran über einem durch SiGe-Opferschichtabscheidung präzise einstellbarem Leerraum eröffnet neue Möglichkeiten in der Anwendung solcher Sensoren. Gleiches gilt für Hochfrequenzschalter, wobei eine auslenkbare Zunge für die Kontaktierung sorgt. In Mobiltelefonen werden intelligente und dynamische Antennenanpass-Schaltungen notwendig, um bei den immer kleiner werdenden Abmessungen der Geräte ausreichende Empfangs- und Sendequalitäten sicherzustellen. Unter Varaktoren werden hierbei variable, digital einstellbare Kapazitäten verstanden, welche sich wegen ihrer guten elektrischen Eigenschaften für die Anpass-Netzwerke einsetzen lassen.

### Zeichnung

Die vorliegende Erfindung wird anhand einer Ausführungsform in der nachfolgenden Zeichnung erläutert. Es zeigen:

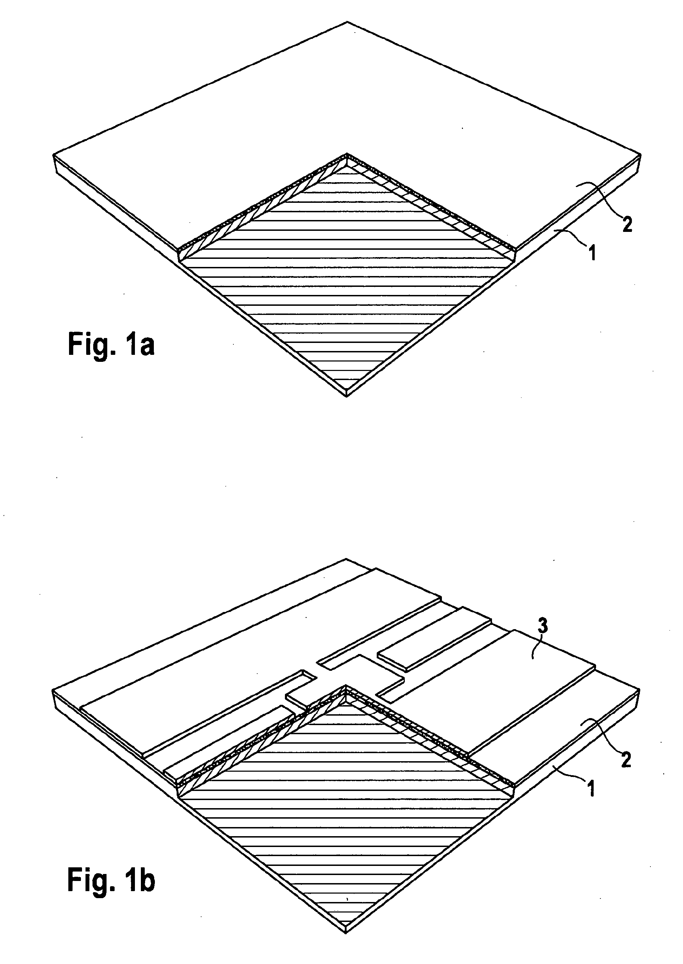

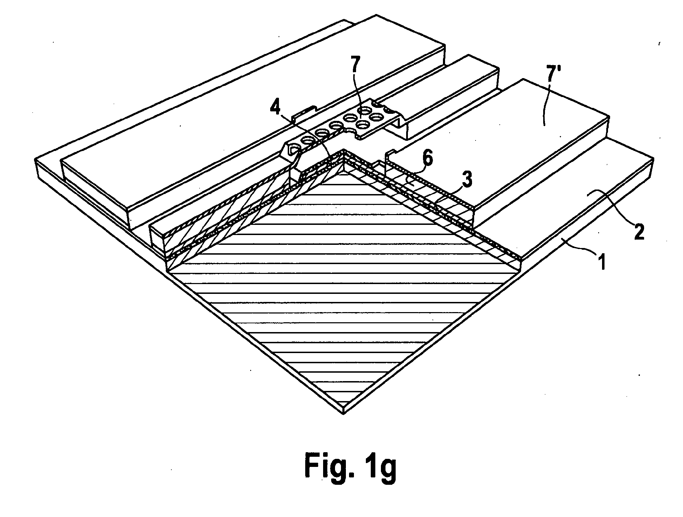

- FIG. 1a-1g: Schritte eines erfindungsgemäßen Verfahrens

Die Figuren 1a bis 1g zeigen das erfindungsgemäße Verfahren anhand einer weiteren Ausführungsform. Zur besseren Darstellung sind die Figuren teilweise als Anschnittdarstellungen ausgeführt.

Der erste Verfahrensschritt in FIG. 1a ist die thermische Oxidierung eines Silizium-Wafers 1. Hierbei wird auf dem Grundmaterial eines Siliziumwafers 1 thermisch eine Siliziumdioxidschicht 2 erzeugt. Vorteilhafterweise ist der Siliziumwafer 1 so beschaffen, dass er hinsichtlich Reinheit oder anderer Parameter für Anwendungen in der Hochfrequenztechnik geeignet ist.

FIG. 1b zeigt den nächsten Schritt. Dieser beinhaltet das Auftragen und die Strukturierung einer ersten Elektrode 3 auf der Oxidschicht 2 des Silizium-Wafers 1. Das Material dieser Elektrode kann beispielsweise Aluminium, Nickel, Kupfer und/oder Gold umfassen. Dieses Strukturieren der ersten Elektrode 3 kann auch als Startmetallisierung bezeichnet werden.

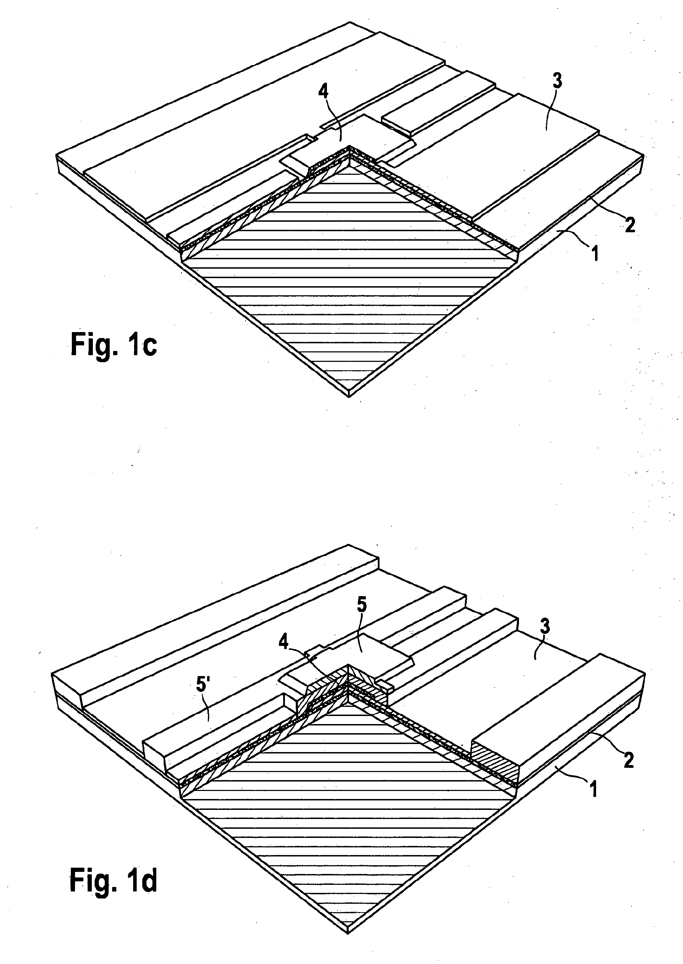

Der in FIG. 1c dargestellte nächste Schritt betrifft das Abdecken zumindest eines Teils der ersten Elektrode 3 mit einer Siliziumdioxidschicht 4. Hierdurch wird also ein Dielektrikum auf wenigstens einen Teil der Elektrode aufgetragen.

FIG. 1d zeigt dann das Abscheiden und die Strukturierung einer SiGe-Opferschicht 5, 5', so dass diese die Siliziumdioxidschicht 4 bedeckt. Hier wird also durch das Strukturieren der Opferschicht definiert, welcher Bereich später freigestellt werden soll. Zusätzlich können weitere Teile der Anordnung mit einer SiGe-Opferschicht bedeckt werden, wenn sie im späteren Verlauf des Verfahrens freigestellt werden sollen. So wird in FIG. 1d noch die weitere Opferschicht 5' aufgebaut. Die SiGe-Opferschicht kann ganzflächig aufgebracht und dann entsprechend strukturiert werden.

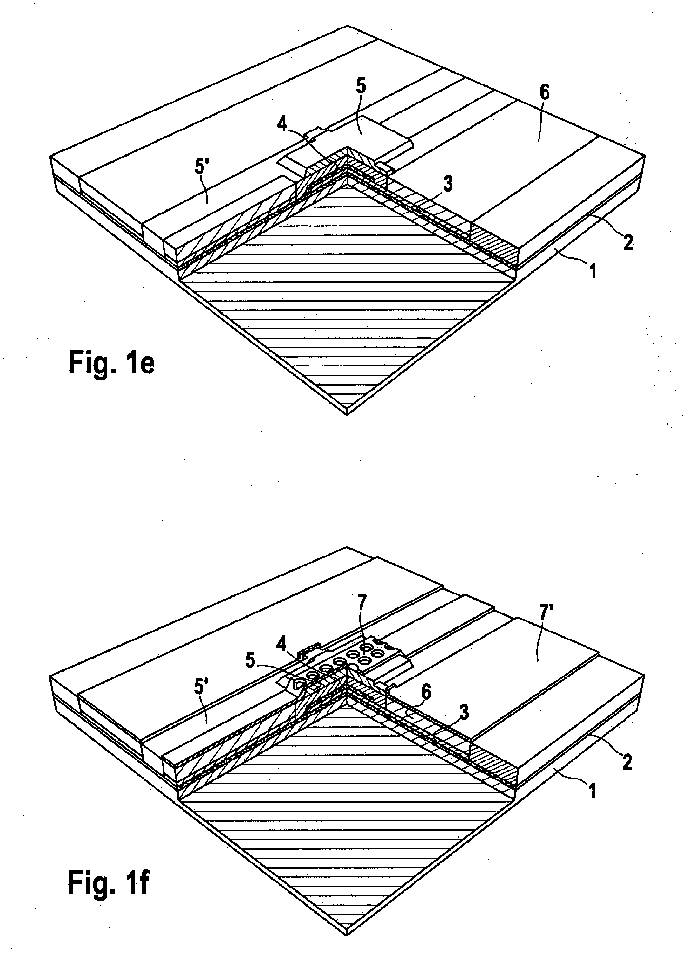

In FIG. 1e wird der nächste Verfahrensschritt dargestellt. Dieser betrifft ein optionales Abscheiden von Metall 6 auf den freien Flächen der ersten Elektrode 3 aus dem zweiten Schritt. Der zweite Verfahrensschritt wurde zu FIG. 1b erläutert. Insgesamt werden die offenen Flächen der Startmetallisierung verstärkt, so dass die Zielabmessung der Elektrode erreicht wird. Das Abscheiden kann galvanisch geschehen, wie beispielsweise im Fall von Nickel, Kupfer und/oder Gold. Aluminium hingegen kann mittels Sputtern abgeschieden werden.

Der nächste Schritt gemäß FIG. 1f ist das Aufbringen einer Aluminium, Gold, Tantal, Titan und/oder Titan-Wolfram umfassenden Schicht 7 auf die SiGe-Opferschicht 5 aus dem vierten Schritt. Dieser Schritt wurde in FIG. 1d gezeigt. Diese Schicht 7 wird später eine Membran werden. In FIG. 1f ist noch zu sehen, dass diese Schicht 7 noch weiter strukturiert werden kann, indem Löcher in ihr erzeugt werden. Bevorzugtes Material für diese Schicht ist Aluminium.

An das Aufbringen dieser Schicht 7 schließt sich ein Tempern des Silizium-Wafers bei einer Temperatur von ≥ 100 °C bis ≤ 400 °C an. Durch das Tempern des Wafers und somit auch der auf dem Wafer befindlichen Strukturen wird erreicht, dass die Hystereseeigenschaften der erzeugten metallischen Membranschichten kontrollierbar werden und reproduzierbar eingestellt werden können. Auch auf die zuvor abgeschiedenen Metallschichten 6 kann eine zusätzliche Metallschicht aufgetragen werden, welche anschließend getempert wird. Dieses ist in FIG. 1f durch die Schicht 7' dargestellt.

Als letzter Schritt wird das Ätzen der Opferschicht 5, 5' mittels ClF₃ durchgeführt. Das Endergebnis ist in FIG. 1f dargestellt. Unter der Membran 7 befindet sich nun ein Leerraum. Insgesamt wird ein Hochfrequenzschalter erhalten, in dem die vorzugsweise Aluminium, alternativ aber auch Gold, Tantal, Titan und/oder Titan-Wolfram umfassende Schicht elektrostatisch geschaltet werden kann.

## Patentansprüche

1. Verfahren zur Herstellung von mikromechanischen Drucksensoren mit einer ganz oder teilweisen als Membran ausgeführten Metallschicht (3, 6, 7, 7'), wobei ein Substrat (1) zumindest mit der Metallschicht (3, 6, 7, 7') sowie einer SiGe umfassenden Opferschicht (5, 5') strukturiert wird und wobei weiterhin die Opferschicht (5, 5') durch Ätzen mit einer fluorhaltigen Verbindung mindestens teilweise wieder entfernt wird, **dadurch gekennzeichnet, dass** vor dem Ätzen der Opferschicht (5, 5') das Substrat (1), welches die Opferschicht (5, 5') und die Metallschicht (3, 6, 7, 7') trägt, bei einer Temperatur von ≥ 100 °C bis ≤ 400 °C getempert wird.

2. Verfahren nach Anspruch 1, wobei die Metallschicht (3, 6, 7, 7') Aluminium, Gold, Tantal, Titan und/oder Titan-Wolfram umfasst.

3. Verfahren nach Anspruch 1 oder 2, wobei die zum Ätzen verwendete fluorhaltige Verbindung ausgewählt ist aus der Gruppe umfassend ClF₃, ClF₅, BrF₃, BrF₅, IF₃, IF₅, IF₇ und/oder XeF₂.

4. Verfahren nach einem der Ansprüche 1 bis 3, wobei das Strukturieren des Substrats (1) mit der Metallschicht (7) dergestalt ausgeführt wird, dass die Metallschicht (7) zumindest teilweise auf die Opferschicht (5) aufgetragen wird.

5. Verfahren nach einem der Ansprüche 1 bis 4, umfassend die Schritte:
a) Thermische Oxidierung eines Silizium-Wafers (1);
b) Auftragen und Strukturierung einer ersten Elektrode (3) auf der Oxidschicht (2) des Silizium-Wafers (1);
c) Abdecken zumindest eines Teils der ersten Elektrode (3) mit einer Siliziumdioxidschicht (4);
d) Abscheiden und Strukturierung einer SiGe-Opferschicht (5, 5'), so dass diese die Siliziumdioxidschicht (4) bedeckt;
e) Optionales Abscheiden von Metall (6) auf den freien Flächen der ersten Elektrode (3) aus Schritt b);
f) Aufbringen einer Aluminium, Gold, Tantal, Titan und/oder Titan-Wolfram umfassenden Schicht (7) auf die SiGe-Opferschicht (5) aus Schritt d);
g) Tempern des Silizium-Wafers bei einer Temperatur von ≥ 100 °C bis s 400 °C;
h) Ätzen der Opferschicht (5) mittels ClF₃.

6. Mikromechanischer Drucksensor, hergestellt durch ein Verfahren nach einem der Ansprüche 1 bis 5.

7. Mikromechanischer Drucksensor nach Anspruch 6, umfassend eine Metallschicht (3, 6, 7, 7'), wobei das Material der Metallschicht in einem polykristallinen Gefüge vorliegt und wobei ≥ 90% der Kristallite eine Größe von ≥ 1 µm bis ≤ 100 µm aufweisen.

8. Mikromechanischer Drucksensor nach Anspruch 6 oder 7, wobei die Metallschicht (3, 6, 7, 7') Aluminium, Gold, Tantal, Titan und/oder Titan-Wolfram umfasst.

## Claims

1. Method for producing micromechanical pressure sensors having a metal layer (3, 6, 7, 7') configured entirely or partially as a membrane, wherein a substrate (1) is structured at least with the metal layer (3, 6, 7, 7') and also an SiGe-comprising sacrificial layer (5, 5'), and wherein furthermore the sacrificial layer (5, 5') is at least partially removed again by etching with a fluorine-containing compound, **characterized in that**, before the sacrificial layer (5, 5') is etched, the substrate (1), which carries the sacrificial layer (5, 5') and the metal layer (3, 6, 7, 7'), is heat-treated at a temperature of ≥ 100°C to ≤ 400°C.

2. Method according to Claim 1, wherein the metal layer (3, 6, 7, 7') comprises aluminium, gold, tantalum, titanium and/or titanium-tungsten.

3. Method according to Claim 1 or 2, wherein the fluorine-containing compound used for etching is selected from the group consisting of ClF₃, ClF₅, BrF₃, BrF₅, IF₃, IF₅, IF₇ and/or XeF₂.

4. Method according to one of Claims 1 to 3, wherein the structuring of the substrate (1) with the metal layer (7) is carried out in such a manner that the metal layer (7) is applied at least partially to the sacrificial layer (5).

5. Method according to one of Claims 1 to 4, comprising the following steps:
a) thermally oxidizing a silicon wafer (1);
b) applying and structuring a first electrode (3) on the oxide layer (2) of the silicon wafer (1) ;
c) covering at least part of the first electrode (3) with a silicon dioxide layer (4);
d) depositing and structuring an SiGe sacrificial layer (5, 5') such that it covers the silicon dioxide layer (4);
e) optionally depositing metal (6) on the free surfaces of the first electrode (3) from step b) ;
f) applying a layer (7) comprising aluminium, gold, tantalum, titanium and/or titanium-tungsten to the SiGe sacrificial layer (5) from step d);
g) heat-treating the silicon wafer at a temperature of ≥ 100°C to ≤ 400°C;
h) etching the sacrificial layer (5) by means of ClF₃.

6. Micromechanical pressure sensor, produced by a method according to one of Claims 1 to 5.

7. Micromechanical pressure sensor according to Claim 6, comprising a metal layer (3, 6, 7, 7'), wherein the material of the metal layer is present in a polycrystalline microstructure, and wherein ≥ 90% of the crystallites have a size of ≥ 1 µm to ≤ 100 µm.

8. Micromechanical pressure sensor according to Claim 6 or 7, wherein the metal layer (3, 6, 7, 7') comprises aluminium, gold, tantalum, titanium and/or titanium-tungsten.

## Revendications

1. Procédé de fabrication de capteurs de pression micromécaniques munis d'une couche métallique (3, 6, 7, 7') entièrement ou partiellement réalisée sous la forme d'une membrane, un substrat (1) étant structuré au moins avec la couche métallique (3, 6, 7, 7'), ainsi qu'avec une couche sacrificielle (5, 5') contenant du SiGe, et la couche sacrificielle (5, 5') étant en outre de nouveau retirée au moins partiellement par gravure avec un composé contenant du fluor, **caractérisé en ce qu'**avant la gravure de la couche sacrificielle (5, 5'), le substrat (1) qui supporte la couche sacrificielle (5, 5') et la couche métallique (3, 6, 7, 7') est recuit à une température ≥ 100 °C à ≤ 400 °C.

2. Procédé selon la revendication 1, selon lequel la couche métallique (3, 6, 7, 7') contient de l'aluminium, de l'or, du tantale, du titane et/ou un alliage titane-tungstène.

3. Procédé selon la revendication 1 ou 2, selon lequel le composé contenant du fluor qui est utilisé pour la gravure est choisi dans le groupe comprenant le ClF₃, le ClF₅, le BrF₃, le BrF₅, l'IF₃, l'IF₅, l'IF₇ et/ou le XeF₂.

4. Procédé selon l'une des revendications 1 à 3, selon lequel la structuration du substrat (1) avec la couche métallique (7) est réalisée de telle sorte que la couche métallique (7) est appliquée au moins partiellement sur la couche sacrificielle (5).

5. Procédé selon l'une des revendications 1 à 4, comprenant les étapes suivantes :
a) oxydation thermique d'une galette en silicium (1) ;
b) application et structuration d'un première électrode (3) sur la couche d'oxyde (2) de la galette en silicium (1) ;
c) recouvrement d'au moins une partie de la première électrode (3) avec une couche de dioxyde de silicium (4) ;
d) précipitation et structuration d'une couche sacrificielle (5, 5') en SiGe de manière à ce que celle-ci recouvre la couche de dioxyde de silicium (4) ;
e) précipitation facultative de métal (6) sur les surfaces libres de la première électrode (3) de l'étape b) ;
f) application d'une couche (7) contenant de l'aluminium, de l'or, du tantale, du titane et/ou un alliage titane-tungstène sur la couche sacrificielle (5, 5') en SiGe de l'étape d) ;
g) recuit de la galette en silicium à une température ≥ 100 °C à ≤ 400 °C ;
h) gravure de la couche sacrificielle (5) avec du ClF₃.

6. Capteur de pression micromécanique, fabriqué par un procédé selon l'une des revendications 1 à 5.

7. Capteur de pression micromécanique selon la revendication 6, comprenant une couche métallique (3, 6, 7, 7'), le matériau de la couche métallique étant présent dans une structure polycristalline et ≥ 90 % des cristallites présentant une taille de ≥ 1 µm à ≤ 100 µm.

8. Capteur de pression micromécanique selon la revendication 6 ou 7, avec lequel la couche métallique (3, 6, 7, 7') contient de l'aluminium, de l'or, du tantale, du titane et/ou un alliage titane-tungstène.
